# EUROPEAN PATENT SPECIFICATION

(11) **EP 0 501 696 B1**
(45) Date of publication and mention of the grant of the patent: **23.12.1998**
(21) Application number: 92301477.3
(22) Date of filing: 21.02.1992
(51) Int. Cl.: G03F 1/14, G03F 7/20, G03F 7/30, G03F 7/00

(54) **Single-alignment-level lithographic technique for achieving self-aligned features**
Einstufen-Ausrichtung Lithographie-Verfahren zur Erzielung selbst ausgerichtete Merkmale
Exactitude du positionnement des niveaux de la technique lithographique pour obtenir des caractéristiques auto-aligner

(30) Priority: 27.02.1991 US 661761
(43) Date of publication of application: 02.09.1992
(73) Proprietor: AT&T Corp., New York, NY 10013-2412 (US)
(72) Inventor: Pierrat, Christophe, Watchung, New Jersey 07060 (US)
(74) Representative: Johnston, Kenneth Graham

(56) References cited:
- EP-A- 0 383 534
- GB-A- 2 244 349
- US-A- 3 727 233
- US-A- 4 035 522
- MICROELECTRONIC ENGINEERING vol. 1989, no. 9, May 1989, AMSTERDAM,NL pages 47 - 59; FLAGELLO ET AL.: 'A Single Expose Double Develop (SEDD) Process for Self-aligned Lithographic Applications'
- INSPEC Database Institute of Electrical Engineers, LONDON, GB W.V.COLBRAN: 'Hitachi E-Beam Lithography for Advanced Applications', Accession No. B91044720

## Description

### Background of the Invention

This invention relates to optical lithography, as can be used for fabricating semiconductor integrated circuit and other devices, and more particularly to a lithographic technique for making a phase-shifting mask as described in the first part of claim 1 for use in optical systems for lithographically fabricating such devices. These masks are also called "reticles" particularly when used in optical systems having magnifications different from unity.

In fabricating semiconductor integrated circuits, it is desirable to have as many devices, such as transistors, per wafer. Hence it is desirable to have as small a transistor or other feature size as possible, such as the feature size of a metallization stripe--i.e., its width W--or of an aperture in an insulating layer which is to be filled with metal, in order to form electrical connections, for example, between one level of metallization and another. Thus, for example, if it it desired to print the corresponding isolated feature having a width equal to W on a photoresist layer located on a semiconductor wafer in which the circuits are to be integrated, a feature having a width equal to C must be incorporated in the mask (reticle). According to geometric optics, if this feature of width equal to C is a simple aperture in an opaque layer of the mask, then the ratio W/C = m, where m is known as the lateral magnification of the optical system being used to focus the features of the mask onto the photoresist layer. When diffraction effects become important, however, the edges of the image become fuzzy (lose their sharpness); hence the resolution of the mask features when focused on the photoresist layer deteriorates.

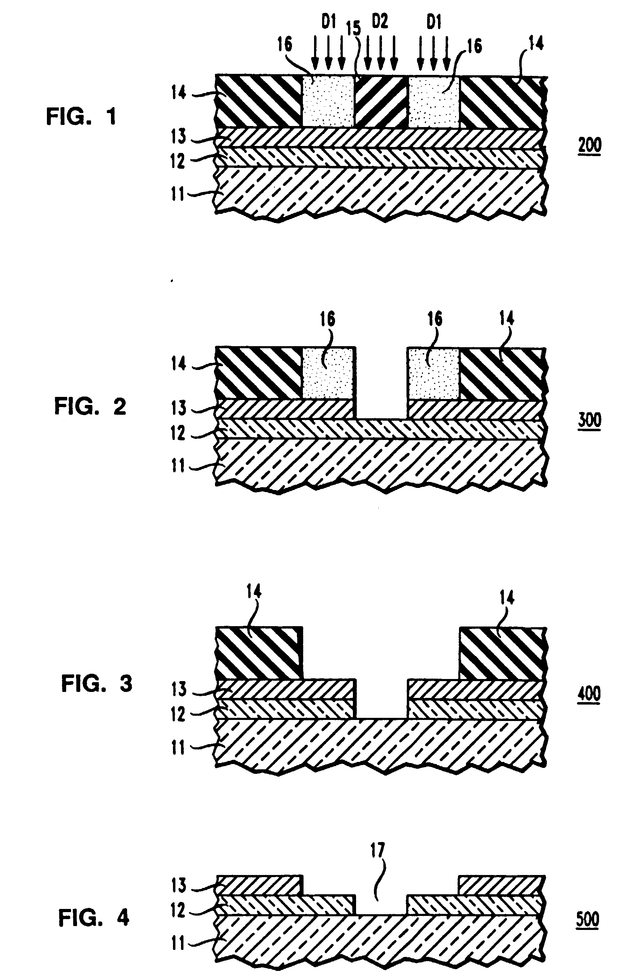

In a paper entitled "New Phase Shifting Mask with Self-Aligned Phase Shifters for a Quarter Micron Lithography" published in International Electron Device Meeting (IEDM) Technical Digest, pp. 57-60 (3.3.1-3.3.4) (December, 1989), A. Nitayama et al. taught the use of masks having transparent phase-shifting portions in an effort to achieve improved resolution--i.e., improved sharpness of the image of the mask features focused on the photoresist layer 101. More specifically, these masks contained suitably patterned transparent optical phase-shifting layers, i.e., layers having edges located at predetermined distances from the edges of the opaque portions of the mask. Each of these phase-shifting layers had a thickness t equal to λ/2(n-1), where λ is the wavelength of the optical radiation from the source 106 (FIG. 1) and n is the refractive index of the phase-shifting layers. Thus, as known in the art, these layers introduced phase shifts (delays) of π radians in the optical radiation. By virtue of diffraction principles, the presence of these phase-shifting layers should produce the desired improved resolution. Such masks are called "phase-shifting" masks.

The mask structure described by A. Nitayama et al., op. cit., was manufactured by a single-alignment-level process involving a step of wet etching an opaque chromium layer located underneath a phase-shifting layer of PMMA which is resistant to the wet etching, whereby the etching of the chromium layer undercut the PMMA layer and formed a phase-shifting mask. However, the lateral etching of the chromium layer is difficult to control, so that the positioning of the edges of the chromium layer is likewise difficult to control. Yet this positioning of the edges of the opaque chromium must be carefully controlled in order to yield the desired improved resolution for the mask.

Moreover, the method taught by A. Nitayama et al. is not sufficiently versatile to make masks having arbitrary features, such as clustered line-space features or isolated apertures having relatively narrow-sized phase-shifting assist-slots. Clustered line-space features, as well as apertures having phase-shifting slots, can be made in accordance with the teachings in a paper by M. D. Levenson et al. entitled "Improved Resolution in Photolithography with a Phase-Shifting Mask," published in IEEE Transactions on Electron Devices, Vol. ED-29, pp. 1828-1836 (1982). The technique taught therein to make such mask devices, however, required two alignment steps (two-alignment-level method), and is therefore undesirable from the standpoints of accurate alignment and decreased throughput of the mask-making procedure (typically electron beam lithography).

"A Single Expose Double Develop (SEDD) Process for Self-aligned Lithographic Applications", Microelectronic Engineering, Vol. 1989, No. 9, May 1989, pages 47-59 describes a self aligned process where three different doses of radiation are introduced into a resist layer as defined in the preamble of claim 1.

"Hitachi E-Beam Lithography for Advanced Applications", IEEE 10th Annual Symposium on Microlithography, September 26-27th 1990, Sunnyvale, CA, USA discusses the benefits of using several HITACHI electron beam lithography tools for manufacturing reticles and phase-shifting masks.

US-A-4 035 522 discusses variable resist exposure using an x-ray lithography system.

EP-A-0 383 534 discloses phase-shift photomasks.

Therefore, it would be desirable to have a more versatile and more controllable single-alignment-level method of manufacturing phase-shifting masks. More generally, it would be desirable to have a more versatile and more controllable single-alignment-level lithographic technique for achieving self-aligned features.

### Summary of the Invention

In accordance with the invention, I provide a technique as set forth in claim 1. In addition, it is advantageous that the technique have the features recited in claims 2 to 6.

### Brief Description of the Drawing

This invention, together with its various features and advantages, can be readily understood from the following detailed description taken in conjunction with the accompanying drawing in which:

In specific embodiments, a positive tone resist layer (FIGS. 14) or a negative tone resist layer (FIGS.5-8) can be used in conjunction with electrons as the radiation.
FIGS. 1-4 are side elevational views in cross section showing various stages in the manufacture of a phase-shifting mask, in accordance with a specific embodiment of the invention; and
FIGS. 5-8 are side elevational views in cross section showing various stages in the manufacture of a phase-shifting mask, in accordance with another specific embodiment of the invention.

Only for the sake of clarity, none of the drawings is to scale.

### Detailed Description

Referring now to the drawings, FIG. 1 shows an early device stage 200 in the making of an illustrative portion of a desired phase-shifting mask 500 (FIG. 4). For the sake of definiteness, it will be assumed that the desired feature in this portion of the mask is a square aperture, but it should be understood that other features can be made in accordance with the invention, such as a circular aperture or a line-space feature, by modifying the contours of the various regions to be formed in the resist layer described below, whereby such features as clustered line-space features can be attained.

Substrate 11 is a dielectric, typically uniformly thick amorphous quartz. In any event, it is transparent to the wavelength λ to be used in the optical system in which features of the mask are focused on a photoresist layer, for example. Layer 12 is a transparent (to the wavelength λ) phase-shifting layer, e.g., uniformly thick spun-on glass, located on a major surface of the quartz substrate 11 itself. Alternatively, the layer 12 can be omitted.

For phase-shifting by π radians, the thickness of the phase-shifting layer 12 is everywhere equal to λ/2(n-1), where λ is the vacuum wavelength to be used in the optical system and n is the refractive index of the material in the layer 12. In case this layer 12 is omitted, then the depth of the trench 17 resulting in the substrate 11, instead of in the layer 12, is also equal to λ/2(n-1) but where n is refractive index in the substrate 11.

Layer 13 is an opaque layer, typically chromium having a uniform thickness of 0.1 µm which has been deposited on the top major surface of the phase-shifting layer 12 or in the absence of this layer 12 directly on the top major surface of the substrate 11.

Region 14 is a portion of a uniformly thick positive tone resist layer, typically a polymer such as polycresolformaldehyde sensitized with substituted 1,2 napthoquinone diazide, having a uniform thickness of 0.5 µm. Such a resist is supplied by the Shipley Company under the trademark of MP2400. The resist layer is bombarded with electrons in the amount of doses D2 and D1 of electrons in regions 15 and 16, respectively. The dose D2 is greater than D1. For example, D2 is about 20 micro-coulombs per square centimeter, and the dose D1 is about 10 micro-coulombs per square centimeter, both doses at 20 keV. Typically, the outer contours of the region 15 form a square, and the contours of the region 16 form a square ring, but other contours are feasible as noted above.

After the electron bombardment, the resist is developed in a suitable developer which removes the region 15 of the resist but not region 14 or 16. For example, AZ2401 developer (Shipley) diluted in water, in a dilution of 1 volume of developer in 5 volumes of water, can be used for about 8 minutes. Then the portion of the chromium layer 13 underlying the (removed) original resist region 15 is etched, typically by means of wet etching with cerric ammonium nitrate solution or dry etching with a chlorinated gaseous plasma. At this point of the process, device stage 300 (FIG. 2) is attained.

Next, the resist is further developed, this time in a suitable--typically more concentrated developer which removes the resist region 16, but again not the resist region 14. For example, AZ2401 developer supplied by Shipley, in a dilution of 1 volume of developer in 4 volumes of water, can be used for about 5 minutes. Then the spun-on glass layer 12 is etched down to its interface with the quartz substrate 11; or, in the absence of the layer 12, the quartz substrate is etched--for example, either with a wet etching solution of buffered hydrofluoric acid in water or with a dry CHF₃ plasma. At this point of this process, stage 400 (FIG. 3) is attained.

Next, the exposed portion of the chromium layer--viz. the portion underlying the (removed) original resist region 16--is etched by means of wet or dry etching. Finally, the remaining resist region 14 is removed, typically by means of a suitable wet etching with a wet organic solvent or an acid solution, or a dry etching with an O₂ plasma, whereby the desired phase-shifting mask 500 (FIG. 4) is obtained.

Note that the etching of layer 12 (or substrate 11) can be performed just prior to the removal of the resist region 16 especially if the etching of layer 12 (or substrate 11) is a wet etching process, since such a process usually does not modify the resist region 16. To remove any unwanted residues, if need be, an oxygen plasma treatment can be added after any etching step or any developing step.

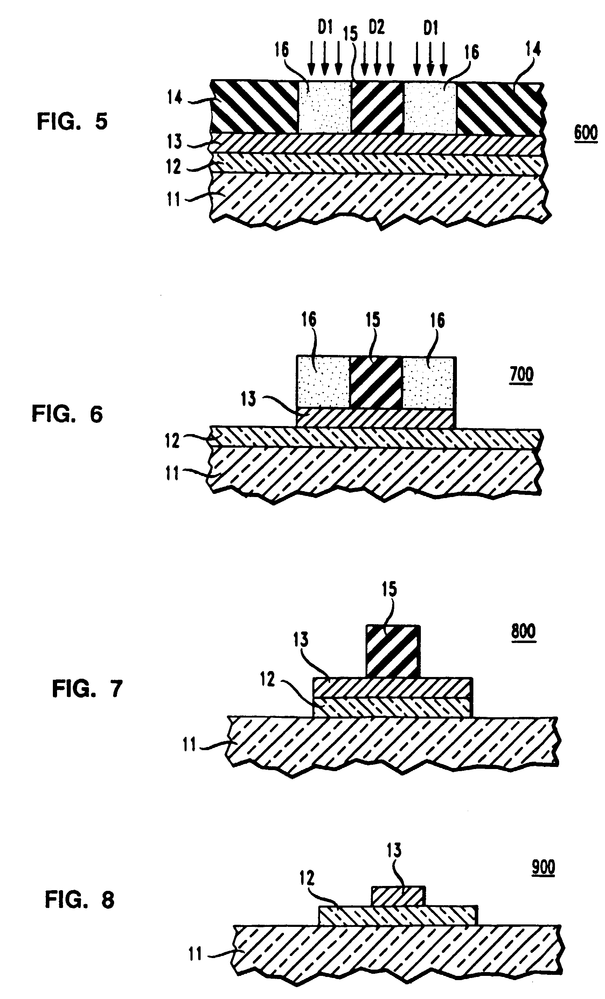

Referring now to FIG. 5, an early stage 600 in the making of an illustrative portion of a desired phase-shifting mask 900 (FIG. 8) for use as the reticle in the aforementioned optical system, in accordance with another specific embodiment of the invention. Here in FIG. 5, all elements are the same as in FIG. 1 and are given the same reference numerals, except that the resist material in the stage 600 is negative tone. This resist material can be, for example, an SAL601 resist, as supplied by Shipley, uniformly 0.5 µm thick, baked on a hot plate at 70°C for 4 minutes. The resist layer is bombarded in regions 15, 16, and 14 with electron doses D2, D1, and substantially zero, respectively. Typically, D2 is equal to approximately 7 micro-coulombs per square centimeter, D1 is approximately equal to 4 micro-coulombs per square centimeter, and all the electrons have been accelerated to approximately 20 keV.

After the electron bombardment, the resist is developed, typically for 4 minutes with a wet developer such as an 0.27 N aqueous solution of tetramethylammonium hydroxide. In this way, resist region 14, but not region 15 or 16, is removed. To remove undesired residues if need be, an oxygen plasma treatment can be used. Then the portion of the chromium layer 13 underlying the (removed) original resist region 14 is dry or wet etched. For example, a wet etching with cerric ammonium nitrate solution can be used for this purpose. At this point of the process, device stage 700 (FIG. 6) is attained.

Next, the resist is further developed by means of a more concentrated developing solution, typically by means of an aqueous 0.54 N solution of tetramethylammonium hydroxide for 4 minutes. Again, as above, an oxygen plasma can be used to remove unwanted residues. Then the spun-on glass layer 12, or in its absence the quartz substrate 11, is etched. For example, (in the absence of the spun-on glass layer 12) the quartz substrate 11 is dry etched for 9 minutes by means of a CHF₃ plasma at about 100 sccm, 2.7 Pa, 200 Watt, in a Plasma Therm SL720 etching chamber. In this way, the exposed portions of the quartz substrate 11 are etched to a depth of 385 nm. Unwanted residues can then be removed by an oxygen plasma treatment. At this point, the device stage 800 (FIG. 7) is attained.

Next, the chromium layer 12 is etched again, typically by means of a treatment with a cerric ammonium nitrate solution, whereby only the portions of the chromium layer 13 underlying the resist region 15 remain, whereas the portions of the chromium layer 13 underlying the (by now removed) original resist regions 14 and 16 have been removed. Finally, the resist region 15 is removed, as by means of a plasma treatment. At this point, the desired phase-shifting mask 900 (FIG. 8) is attained, which can be used as the reticle in the aforementioned optical system.

Note that the above-mentioned oxygen plasma treatments to remove unwanted residues (if any) are not mandatory but are optional.

Although the invention has been described in terms of specific embodiments, various modifications can be made without departing from the scope of the claims. Instead of chromium for the opaque layer 13, other sufficiently opaque materials such as molybdenum silicide can be used. The spun-on glass layer 12, as noted above, can be omitted or can be replaced with other materials that can be selectively etched with respect to--i.e., have higher etch rates than--the underlying (quartz) substrate, such as silicon dioxide which has been chemically vapor deposited on the substrate. Moreover, thicknesses of the phase-shifting layer corresponding to phase-shifts other than π radian can also be used, in accordance with diffraction principles.

## Claims

1. A lithographic technique for making a phase-shifting mask comprising introducing into first, second, and third regions (FIG. 1: 15, 16, 14; FIG. 5: 14, 16, 15) of a resist layer mutually differing first, second, and third doses of resist-modifying radiation per unit area (FIG. 1: D2, D1, 0; FIG. 5: 0, D1, D2), respectively, the resist layer being located upon a first material layer (13) which is located upon a second material layer (12), the first region being contiguous with and having a first common boundary with the second region, and the second region being contiguous with and having a second common boundary with the first region, the first material layer being optically absorbing and the second material layer being transparent with respect to prescribed optical radiation; subjecting the resist layer to a first development procedure, whereby the first region (FIG. 2:15, FIG. 6: 14), but not the second or third regions, of the resist layer is dissolved, characterized by the steps of:
(a) etching the first material layer (13), but not the second material layer, solely in a region thereof underlying the original first region (FIG. 1: 15; FIG. 5: 14) of the resist layer;
(b) subjecting the resist layer to a second development procedure, whereby the second region (FIG. 3: 16; FIG. 7: 16) but not the third region (FIG. 3: 14; FIG. 7: 15) of the resist layer is dissolved;
(c) etching a thickness of the second material layer (12) solely in a region underlying the original first region (FIG. 1: 15; FIG. 5: 14) of the resist layer, whereby the thickness of the second material layer (12) is reduced thereat; and
(d) etching the first material layer (13) in a region thereof underlying the original second region (FIG. 1: 16; FIG. 5: 16) of the resist layer,
wherein the order of sequence of the steps is (a), (b), (c), (d),
whereby there are created an edge in the first material layer (13) and an edge in the second material layer (12) that are aligned with the second and first common boundaries, respectively.

2. The technique of claim 1 in which the third dose is substantially zero, the resist is a positive tone resist and the first dose (D2) of radiation per unit area is greater than the second dose (D1).

3. The technique of claim 2 in which the radiation is essentially electrons.

4. The technique of claim 1 in which the first dose is substantially zero, the resist is a negative tone resist, and the third dose of radiation per unit area (D2) is greater than the second dose (D1).

5. The technique of claim 4 in which the radiation is essentially electrons.

6. The technique of claim 1 in which the second material layer (12) is located on a substrate composed of a third material, and in which the entire thickness of the second material layer (12) underlying the original first region of the resist layer is removed during step (c).

## Patentansprüche

1. Lithographisches Verfahren zur Erzeugung einer phasenverschiebenden Maske, bei dem in erste, zweite und dritte Bereiche (FIG. 1: 15, 16, 14; FIG. 5: 14, 16, 15) einer Resistschicht voneinander verschiedene erste, zweite bzw. dritte Dosen von resistmodifizierender Strahlung pro Flächeneinheit eingeführt werden (FIG. 1: D2, D1, 0; FIG. 5: 0, D1, D2), wobei sich die Resistschicht auf einer Schicht (13) aus erstem Material befindet, die sich auf einer Schicht (12) aus zweitem Material befindet, wobei der erste Bereich mit dem zweiten Bereich zusammenhängt und einen ersten gemeinsamen Rand mit diesem aufweist und der zweite Bereich mit dem ersten Bereich zusammenhängt und einen zweiten gemeinsamen Rand mit diesem aufweist, wobei die Schicht aus erstem Material optisch absorbierend und die Schicht aus zweitem Material in bezug auf vorgeschriebene optische Strahlung transparent ist; die Resistschicht einer ersten Entwicklungsprozedur unterworfen wird, wodurch der erste Bereich (FIG. 2: 15, FIG. 6: 14), aber nicht der zweite und dritte Bereich der Resistschicht aufgelöst wird, gekennzeichnet durch die folgenden Schritte:
(a) Ätzen der Schicht (13) aus erstem Material, aber nicht der Schicht aus zweitem Material, ausschließlich in einem Bereich dieser, der unter dem ursprünglichen ersten Bereich (FIG. 1: 15; FIG. 5: 14) der Resistschicht liegt;
(b) Anwenden einer zweiten Entwicklungsprozedur auf die Resistschicht, wodurch der zweite Bereich (FIG. 3: 16; FIG. 7: 16), aber nicht der dritte Bereich (FIG. 3: 14; FIG. 7: 15) der Resistschicht aufgelöst wird;
(c) Ätzen einer Dicke der Schicht (12) aus zweitem Material ausschließlich in einem Bereich, der unter dem ursprünglichen ersten Bereich (FIG. 1: 15; FIG. 5: 14) der Resistschicht liegt, wodurch die Dicke der Schicht (12) aus zweitem Material dort vermindert wird; und
(d) Ätzen der Schicht (13) aus erstem Material in einem Bereich dieser, der unter dem ursprünglichen zweiten Bereich (FIG. 1: 16; FIG. 5: 16) der Resistschicht liegt,
wobei die Reihenfolge der Schritte (a), (b), (c), (d) ist,
wodurch eine Kante in der Schicht (13) aus erstem Material und eine Kante in der Schicht (12) aus zweitem Material erzeugt werden, die auf die zweiten bzw. ersten gemeinsamen Ränder ausgerichtet sind.

2. Verfahren nach Anspruch 1, wobei die dritte Dosis im wesentlichen Null ist, das Resist ein Positiv-Resist ist und die erste Dosis (D2) von Strahlung pro Flächeneinheit größer als die zweite Dosis (D1) ist.

3. Verfahren nach Anspruch 2, wobei es sich bei der Strahlung im wesentlichen um Elektronen handelt.

4. Verfahren nach Anspruch 1, wobei die erste Dosis im wesentlichen Null ist, das Resist ein Negativ-Resist ist und die dritte Dosis von Strahlung pro Flächeneinheit (D2) größer als die zweite Dosis (D1) ist.

5. Verfahren nach Anspruch 4, wobei es sich bei der Strahlung im wesentlichen um Elektronen handelt.

6. Verfahren nach Anspruch 1, wobei sich die Schicht (12) aus zweitem Material auf einem Substrat befindet, das aus einem dritten Material zusammengesetzt ist und wobei die gesamte Dicke der Schicht (12) aus zweitem Material unter dem ursprünglichen ersten Bereich der Resistschicht während des Schritts (c) entfernt wird.

## Revendications

1. Technique lithographique pour réaliser un masque de déphasage comprenant
l'introduction dans des première, deuxième et troisième régions (figure 1 : 15, 16, 14 ; figure 5 : 14, 16, 15) d'une couche de résist de première, deuxième et troisième doses mutuellement différentes de rayonnement de modification de résist par unité de surface (figure 1: D2, D1, 0 ; figure 5 : 0, D1, D2), respectivement, la couche de résist étant située sur une première couche de matière (13) qui est située sur une deuxième couche de matière (12), la première région étant contiguë à et ayant une première limite commune avec la deuxième région, et la deuxième région étant contiguë à et ayant une deuxième limite commune avec la première région, la première couche de matière étant optiquement absorbante et la deuxième couche de matière étant transparente par rapport au rayonnement optique prescrit ; présentation de la couche de résist à une première procédure de développement, par laquelle la première région (figure 2 : 15 ; figure 6 : 14) mais pas les deuxième ou troisième régions, de la couche de résist est dissoute, caractérisée par les étapes de :
(a) gravure de la première couche de matière (13), mais pas de la deuxième couche de matière, uniquement dans une région de celle-ci sous-jacente à la première région initiale (figure 1 : 15 ; figure 5 : 14) de la couche de résist ;
(b) présentation de la couche de résist à une deuxième procédure de développement, par laquelle la deuxième région (figure 3 : 16 ; figure 7 : 16) mais pas la troisième région (figure 3 : 14 ; figure 7 : 15) de la couche de résist est dissoute ;
(c) gravure d'une épaisseur de la deuxième couche de matière (12) uniquement dans une région sous-jacente à la première région initiale (figure 1 : 15 ; figure 5 ; 14) de la couche de résist, par laquelle l'épaisseur de la deuxième couche de matière (12) y est réduite ; et
(d) gravure de la première couche de matière (13) dans une région de celle-ci sous-jacente à la deuxième région initiale (figure 1: 16 ; figure 5 : 16) de la couche de résist,
dans laquelle l'ordre de séquence des étapes est (a), (b), (c), (d),
par laquelle sont créés un bord dans la première couche de matière (13) et un bord dans la deuxième couche de matière (12) qui sont alignés avec les deuxième et première limites communes, respectivement.

2. Technique selon la revendication 1, dans laquelle la troisième dose est substantiellement zéro, le résist est un résist à ton positif et la première dose (D2) de rayonnement par unité de surface est supérieure à la deuxième dose (D1).

3. Technique selon la revendication 2, dans laquelle le rayonnement se compose essentiellement d'électrons.

4. Technique selon la revendication 1, dans laquelle la première dose est substantiellement zéro, le résist est un résist à ton négatif, et la troisième dose de rayonnement par unité de surface (D2) est supérieure à la deuxième dose (D1).

5. Technique selon la revendication 4, dans laquelle le rayonnement se compose essentiellement d'électrons.

6. Technique selon la revendication 1, dans laquelle la deuxième couche de matière (12) est située sur un substrat composé d'une troisième matière, et dans laquelle l'épaisseur totale de la deuxième couche de matière (12) sous-jacente à la première région initiale de la couche de résist est éliminée durant l'étape (c).
